Europäisches Patentamt

European Patent Office

Office européen des brevets

(11) Publication number: **0 655 773 A1**

(12) **EUROPEAN PATENT APPLICATION**

(21) Application number: **93830427.6**

(22) Date of filing: **27.10.93**

(51) Int. Cl.6: **H01L 21/033**, H01L 21/308

(43) Date of publication of application:
**31.05.95 Bulletin 95/22**

(84) Designated Contracting States:
**DE FR GB IT**

(71) Applicant: **SGS-THOMSON MICROELECTRONICS S.r.l.**
**Via C. Olivetti, 2**
**I-20041 Agrate Brianza (Milano) (IT)**

(72) Inventor: **Brambilla, Claudio**
**Via Libertà, 9**
**I-20049 Concorezzo (IT)**
Inventor: **Cereda, Manlio Sergio**
**Via IV Novembre, 7**
**I-22050 Lomagna (IT)**
Inventor: **Ravaglia, Andrea**
**Via Risorgimento, 1**
**I-22056 Olgiate Molgora (IT)**

(74) Representative: **Pellegri, Alberto et al**
**c/o Società Italiana Brevetti S.p.A.**
**Via Puccini, 7**
**I-21100 Varese (IT)**

(54) **Lithographic image size reduction.**

(57) A mask having features of a smaller size than a lithographically defined image width is formed by depositing a first layer of a different material from the underlying material to be treated through the openings of the mask. This first layer is lithographically patterned and thereafter a conformally deposited second layer is anisotropically etched, thus leaving residues on vertical definition walls of the first layer. The mask openings are restricted to a controllably reduced width as compared with the width of the lithographically defined window. Empirical relationships between the thicknesses of the deposited layers and the reduction of the lithographic image size that is achieved provide a good dimensional control of the mask openings that are finally produced, adequate for sub-micron line-width processes.

The present invention relates to a method for forming windows having a width that is smaller than the minimum width that can be defined lithographically by the apparatuses being used for the purpose.

An unrelented reduction of the size of single structures in IC is constantly sought through refinements of the apparatuses and of the methods of lithographic definition of "windows" and "islands", through certain layers that are successively stacked, by depositing or otherwise forming them, over a wafer of a semiconducting material.

By the use of the most advanced lithographic technologies, often using a reduced wavelength radiation, for example x-rays or electron beams, for exposing one or more layers of a photoresist that, after developing and eventual hardening treatment, will constitute a mask through which a dry etching or any other treatment Of an underlying layer will be performed, a large scale production of IC with a minimum definition line-width of about 0.6 µm, has been made possible. It is evident from considerations on usable wavelength of the electromagnetic radiation used for exposing the photoresist, on diffraction phenomena and on exposition characteristics of the resist used, that the reduction of the minimum image size implies ever more important investments for the development of extremely sophisticated lithographic techniques.

Methods have been proposed for reducing the size of a lithographically produced image in order to extend the possibility of reduction beyond the minimum lithographically definable width.

The document US-A-4.707,218, discloses one of said methods for reducing the lithographic image size. The method consists in forming over a substrate to be patterned, a thin release layer, composed of a material that may be easily lifted off the substrate by etching or by combustion in an oxygen plasma. Over such a release layer, typically of a photoresist hardened by heat treatment or by exposition to UV radiation, a layer of a photosensitive resist is deposited to be lithographically defined in order to produce a mask with apertures having a width that may be the minimum width that is definable by the lithographic apparatuses used. After having stabilized the defined layer of resist, the width of the windows is reduced by conformally depositing a layer of oxide having an appropriate thickness and by anisotropically etching it in plasma in order to leave residues of oxide having a thickness substantially similar to the thickness of the deposited oxide layer over the vertical walls of the defined layer of photoresist.

Through the opening thus restricted of the photoresist mask and the thin release layer, the substrate may be anisotropically etched thus producing a trench, the width of which may be smaller than the minimum lithographically definable width. The whole defining structure is thereafter removed by etching the release layer onto which is was formed.

The method requires the use of a lithographic definition layer of resist that is relatively thick (from 0.8 to 3 microns) in order to tolerate without excessive damages the deposition of a conformal layer of oxide which commonly takes place at a temperature of over 200°C and the subsequent anisotropic etch, commonly a RIE etch. On the other hand, a relatively large thickness of resist is not compatible with advanced lithographic processes having limited depths of focus and in any case tends to lower the definition characteristics of the photosensitive layer. Moreover, the removal of all the layers resting on the first release layer, does not allow to belately carry out etch corrections, in presence of an incomplete etch of the substrate, or other treatments and operations on the defined area.

There remains a need for a method for lithographic image size reduction that would permit a more precise dimensional control, repeated and/or distinct treatments on the same defined area and more in general, a flexibility of the method to pattern substrates of different kind within a fabrication process of IC, in order to exploit further the process of lithographic image size reduction.

The present invention fully satisfies these needs and objectives.

Basically, the process of the invention for excavating trenches in a substrate or for forming windows through a certain layer, having a width that may be lower than the minimum width that is lithographically definable, consists in depositing a layer of a different material than the one of the substrate or of the layer to be patterned and having a thickness of the same order of magnitude of the reduction of the width of a lithographically definable window that should be obtained. In case an aperture through a metal layer, or through a nitride or polysilicon layer must be formed, the deposited layer may be a silicon oxide, deposited by a PECVD technique (an acronym for Plasma Enhanced, Chemical Vapor Deposition), at a relatively low temperature. In case the material to be patterned is a dielectric layer of an oxide, the deposited layer may be, for example, of polycrystalline silicon (polysilicon).

This first deposited layer is patterned by masking it with a photoresist mask according to normal lithographic procedures that are used in the manufacturing process. These procedures may comprise the deposition of a photosensitive material, for example a resist (photoresist), which is exposed through an optical mask, developed and stabilized. Through the aperture of the resist mask thus formed, and which may have the minimum size of definition that can be achieved by the lithographic process, said first deposited layer is etched under highly anisotropic conditions, for example by a RIE process, until the substrate to be etched or the layer to be patterned is exposed. The patterning walls that are obtained are practically vertical.

After having removed the residual portions of the photoresist mask, a layer having a thickness that is correlated to the distance by which the opening defined by the lithographic process must be reduced is deposited in a conformal manner. Also this second conformally deposited layer is essentially of a material different from the substrate material or from the underlying layer to be patterned, while it may be similar to the material of the first deposited and lithographically patterned layer. In case of trenches to be formed in a semiconducting substrate or in the case of windows to be opened through the thickness of a metal layer (for example an aluminum alloy layer) or of a polysilicon or a nitride layer, the conformally deposited layer may be of a silicon oxide deposited by a low temperature, PECVD technique, as the material of the first deposited layer. Viceversa, in case the underlying layer to be patterned is an oxide, the conformally deposited layer, may be a polysilicon. In practice, materials that can be deposited in a conformal manner, suitable to form a layer of a sufficiently uniform thickness, both on horizontal as well as on vertical surfaces, may be used.

Thereafter, a blanket etching under anisotropic conditions, for example by a RIE technique, is carried out and continued for a time sufficient to eliminate the conformally deposited layer from all horizontal surfaces, leaving residues with a typical tapered cross-section along the vertical patterning walls of the first deposited layer. In practice, the process of the invention employs a similar technique to that employed for forming the so-called "lateral spacers" that are employed for effecting self-aligned implants in MOS structures.

The portions of the first deposited and lithographically defined and patterned layer and the lateral appendices, farmed by conformally deposited a second layer, followed by blanket etching, realize a mask through which the substrate to be etched or the underlying layer through the thickness of which openings must be formed, is etched. The distance between opposing edges of said compound masking structure (width of the window), thus formed over the substrate or the layer to be "opened", is reduced as compared with the original distance between the respective opposing edges of the portions of the first deposited and lithographically patterned layer.

The material of the first deposited and lithographically patterned layer may be an oxide or a polysilicon, both materials, differently from a resist, being perfectly capable of tolerating the thermal conditions of the subsequent deposition process of the second conformally deposited layer and of the subsequent etching, without undergoing flows and/or deformations. This permits a precise dimensional control of the patterns that are finally defined. Moreover, when defining a metal or a polysilicon layer, the mask structure composed of the portions of the first lithographically defined layer and of the "spacers" formed along the vertical definition surfaces, may both be of a deposited oxide, for example a so-called VAPOX, doped with phosphine ($P_2O_5$), and be retained permanently over the patterned layer, to become part of a dielectric layer of isolation/passivation. On the contrary, in other cases, for example when the method of the invention is employed for defining a nitride layer during initial steps of fabrication for patterning active areas, the masking structure may be removed by a selective etching process. In the present context, the adjective "different" as used to distinguish the material of a layer from the material of another layer, basically indicates distinct etch characteristics of the two materials, so that a selective etching of one material may be easily performed without substantially etching the other (different) material.

The different aspects and advantages of the method of the invention will become even clearer through the following description of an important embodiment and by referring to the attached drawings, wherein

**Figures** from **1** to **8** depict, in a sequence, a patterning process of the invention.

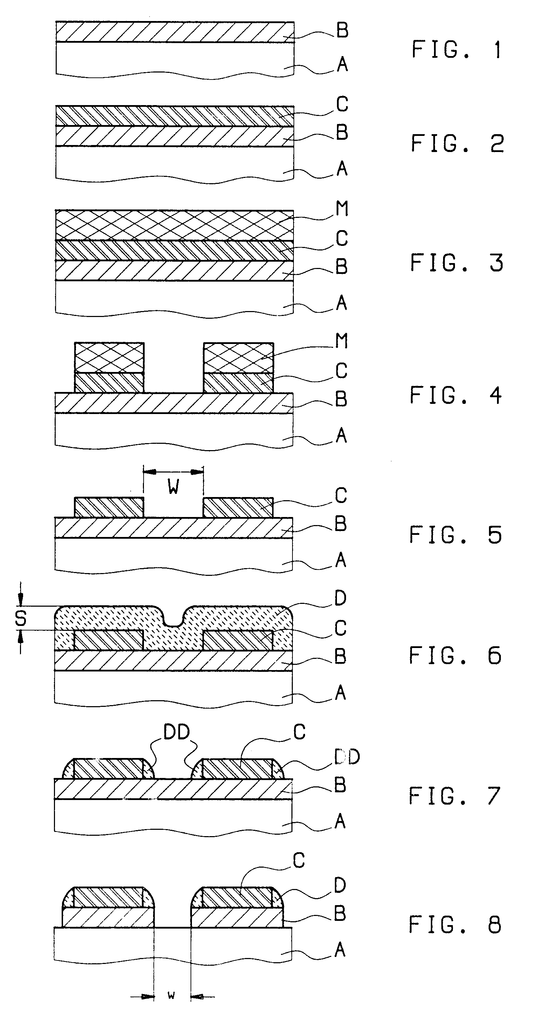

In the set of Figures 1 to 8, is shown the case wherein object of patterning is a layer of a certain material B, formed over a substrate A, and through which windows of a width w, which may also be substantially lower than the minimum width W that can be lithographically defined with the apparatuses and materials being used. Of course, as will be evident to a skilled person, the patterning method of the invention will be equally effective in the case a certain substrate, for example a silicon monocrystal, should be etched in order to form deep trenches having substantially vertical walls.

In the figures, the layer through which of having a "reduced size" must be formed may be a generic layer B that is formed or deposited over the surface of a generic substrate A. For illustrative purposes, the layer B may be a metal layer, for example an aluminum alloy layer or a layer of a doped polysilicon, deposited over a dielectric layer A, for example an oxide layer. The layer B could also be a dielectric layer, for example of a silicon oxide, grown or deposited on the surface of a semiconducting (silicon) substrate A.

The thickness of the layer B is not substantially relevant for the effectiveness of the method of the invention, which permits to perform etchings that may reach a depth of one or more micrometers ($\mu$m).

Reverting to the example taken into consideration, of forming windows through a layer B of a conducting material (an aluminum alloy or a doped polysilicon), the process comprises the deposition of a layer C of a different material of the material of the layer B, for example a silicon oxide deposited by a low temperature, PECVD process. The thickness of the layer C must be of the same order of magnitude of the distance by which a (minimum) lithographically definable width (W) must be reduced. Preferably, the thickness of the layer C is approximately equal to (W-w)/2, where w is the width of the windows that should be formed through the layer B. More generally, the thickness of the layer C may be comprised in a range of ± 30% of the value rendered by the empirical formula (W-w)/2. A thickness lower or higher than these limits render difficult to maintain a good dimensional control of the windows that are produced through the layer B. For example, in the case a lithographically defined width of 0.8$\mu$m must be reduced to 0.4$\mu$m, the thickness of the layer C should be of 0.4 ± 30% $\mu$m, that is it may be comprised between about 0.3$\mu$m (min) and 0.5$\mu$m (max).

Thereafter, a layer of photosensitive material M, for example a layer of resist of 0.7$\mu$m, is deposited over the layer C. The photosensitive layer M of resist is then exposed with the normal apparatuses in use, developed, rinsed and dryed, according to common practices. The width of the defined pattern, may be the minimum line width that can be definable with the exposition apparatuses used. Successively, as schematically depicted in Fig. 4, the layer C is subjected to a dry etching process under highly anisotropic conditions, for example in a RIE plasma, which in the case of a layer C made of an oxide, may be a plasma containing halogen ions, for example fluorine ions.

The residues of the resist mask may be removed by ashing the resist in an oxygen plasma, as depicted in Fig. 5.

At this point, by an appropriate deposition process, a conformal layer D having a markedly uniform thickness of the same order of magnitude of the thickness of the layer C, is deposited, as depicted in Fig. 6. The layer D may be an oxide, for example a VAPOX, doped with phosphine ($P_2O_5$), deposited from a plasma according to a PECVD method at a relatively low temperature (in the vicinity of 200°C). The conformally deposited layer D may be of the same material of the layer C. In any case, it is different from the material of the layer B to be patterned.

A successively performed "blanket" etching, performed under substantially anisotropic conditions and continued until a complete elimination of the deposited layer D from "horizontal" surfaces is attained, leaves a residue DD, having a substantially "triangular" cross section, along the vertical definition edges of the layer C, thus "narrowing" the opening of width W that was lithographically defined before through the layer C, down to a reduced width w.

The mask structure, composed of the portions of the first lithographically defined layer C and of the residues DD, formed along the opposite definition edges of the portions of the layer C, constitute the mask through which the underlying layer B is anisotropically etched, thus producing openings having a width w, which may be smaller than the minimum width W that can be lithographically defined.

Thereafter, the composite masking structure may be removed by a selective etching or more conveniently, in the case of patterning a metal layer, the same masking structure (portions of the layers DD and C), that are constituted by a dielectric material, for example a VAPOX, need not be removed, but they may be "integrated" in a "passivating" dielectric layer that is successively deposited thereon. Furthermore, the peculiar trapezoidal (tapered) shape of the openings that are finally produced, greatly improves the so-called "step-coverage" of the patterned features by a subsequently deposited isolation/passivation dielectric layer, usually by a chemical vapor deposition process.

In particular, it has been found that the relative thicknesses of the layer C ($S_C$), of the layer D ($S_D$), are correlated to the restriction (W-w) of a window of width W that must be achieved. The relationship tieing said values, in a case wherein the thickness $S_C$ of the layer C is greater or equal to the thickness $S_D$ of the conformally deposited layer D, is the following:

$$\text{for } S_C \geqq S_D: w \approx W - 2S_D$$

while in the case the thickness $S_C$ is much less than the thickness $S_D$, the relationship becomes:

$$\text{for } S_C << S_D: w \approx W - 2S_C$$

Of course, the above indicated empirical relationships are verified in the case the deposition of the layer C has a markedly conformal character and the subsequent etching is substantially anisotropic. More or less marked deviations from these "ideal" conditions, tend to determine somewhat different relationships, but they are accompanied by a proportional loss of dimensional control, which, in case of the patterning windows of sub-micron sizes, may produce a sensible decrease of the yield of the fabrication process.

## Claims

1. A method for forming a mask having a window of a smaller width than a lithographically defined width, on the surface of a first material, characterized by:

    a) depositing a first layer of a second material different from said first material;

    b) lithographically defining by the use of a photosensitive resist layer a window of a certain width;

    c) anisotropically etching through said lithographically defined window said first layer and removing the resist mask;

    d) conformally depositing a second layer of a material different from said first material;

    e) anisotropically etching said second, conformally deposited layer, leaving residues on vertical definition walls of said first layer;

    f) the opening defined between said residues formed on vertical definition walls of said first layer, having a reduced width as compared with the width of the litographically defined window.

2. A method as defined in claim 1, wherein said first material belongs to the group composed of monocrystalline semiconducting material, dielectric material and conducting material.

3. The method as defined in claim 1, wherein said first material belongs to the group composed of silicon, glass, metal and silicon nitride.

4. The method as defined in claim 1, wherein said first material is a conducting material and said first and said second layers are both of an oxide.

5. The method according to claim 4, wherein said oxide is obtained by chemical vapor deposition.

6. The method as defined in claim 1, wherein the thickness $S_C$ of said first deposited layer, the thickness $S_D$ of said second conformally deposited layer and a distance by which the width of said lithographically defined window is reduced (W-w), satisfy the following relationships:

$$W - w \approx 2S_D, \text{ when } S_C \geq S_D; \text{ or}$$
$$W - w \approx 2S_C, \text{ when } S_C << S_D.$$

7. The method as defined in claim 1, wherein said first material is a dielectric and said first layer and said second conformally deposited layer are both of a polysilicon, deposited by chemical vapor deposition.

EP 0 655 773 A1

FIG. 1

FIG. 2

FIG. 3

FIG. 4

FIG. 5

FIG. 6

FIG. 7

FIG. 8

6

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 491 408 (CONSORZIO PER LA RICERCA SULLA MICROELETTRONICA NEL MEZZOGIORNO) * figures 1-3 * | 1-5 | H01L21/033 H01L21/308 |
| X | IBM TECHNICAL DISCLOSURE BULLETIN. vol. 3, no. 29 , August 1986 , NEW YORK US page 1328 'method to produce sizes in openings in photo images smaller than lithographic minimum size' * the whole document * | 1-3,5,7 | |
| D,X | EP-A-0 265 638 (INTERNATIONAL BUSINESS MACHINES CORPORATION) * the whole document * | 1 | |
| A | IBM TECHNICAL DISCLOSURE BULLETIN. vol. 30, no. 8 , January 1988 , NEW YORK US pages 252 - 253 'methods of forming small contact holes' * the whole document * | 6 | |
| A | US-A-4 792 534 (TSUJI ET AL.) * figures 1A-1D * | | TECHNICAL FIELDS SEARCHED (Int.Cl.6) |
| A | US-A-4 801 350 (MATTOX ET AL.) * figures 1-5 * | | H01L G03F |

The present search report has been drawn up for all claims

| Place of search | Date of completion of the search | Examiner |
|---|---|---|
| THE HAGUE | 11 March 1994 | Barathe, R |